(19) Europäisches Patentamt
European Patent Office
Office européen des brevets

(11) **EP 3 391 161 B1**

(12) **FASCICULE DE BREVET EUROPEEN**

(45) Date de publication et mention de la délivrance du brevet:
**09.10.2019 Bulletin 2019/41**

(21) Numéro de dépôt: **16808965.4**

(22) Date de dépôt: **01.12.2016**

(51) Int Cl.:
*G05B 23/02* $^{(2006.01)}$   *E05F 15/603* $^{(2015.01)}$
*B64C 13/50* $^{(2006.01)}$

(86) Numéro de dépôt international:
**PCT/EP2016/079472**

(87) Numéro de publication internationale:
**WO 2017/102362 (22.06.2017 Gazette 2017/25)**

(54) **PROCÉDÉ DE SURVEILLANCE D'UN SYSTÈME D'ACTIONNEMENT ÉLECTROMÉCANIQUE**

VERFAHREN ZUR ÜBERWACHUNG EINES ELEKTROMECHANISCHEN AKTUATORSYSTEMS

METHOD FOR MONITORING AN ELECTROMECHANICAL ACTUATOR SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2015 FR 1562370**

(43) Date de publication de la demande:
**24.10.2018 Bulletin 2018/43**

(73) Titulaire: **Safran Electronics & Defense**
**92100 Boulogne-Billancourt (FR)**

(72) Inventeurs:
• **MANSOURI, Badr**
**92100 Boulogne Billancourt (FR)**
• **GUYAMIER, Alexandre**
**92100 Boulogne Billancourt (FR)**
• **PIATON, Jérôme**
**92100 Boulogne-Billancourt (FR)**

(74) Mandataire: **Decorchemont, Audrey Véronique Christèle et al**
**CABINET BOETTCHER**
**16, rue Médéric**
**75017 Paris (FR)**

(56) Documents cités:
**EP-A1- 2 902 285    CN-B- 101 964 624**
**FR-A1- 3 013 465    FR-A1- 3 016 325**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne un procédé de surveillance d'un système d'actionnement électromécanique.

ARRIERE-PLAN TECHNOLOGIQUE DE L'INVENTION

Dans un aéronef, différents éléments mobiles tels que les ailerons, les gouvernes ou encore le capot de l'inverseur de poussée sont associés à des actionneurs pour pouvoir être déplacés entre une position neutre et une position active. A cet effet, chaque actionneur est entraîné par un moteur selon un mouvement de translation entre deux butées. A titre d'exemple, dans le cas d'un volet, une première butée est associée à la position neutre de l'élément mobile et une deuxième butée est associée à la position active de l'élément mobile. Dès lors, lorsque le moteur est alimenté, il entraîne l'actionneur qui déplace à son tour l'élément mobile associé.
Afin de détecter les éventuelles défaillances ou vieillissement de la chaîne d'actionnement de l'élément mobile, il convient de surveiller le moteur et l'actionneur ce qui est usuellement mis en oeuvre à l'aide de capteurs associés au moteur et/ou à l'actionneur.
Toutefois les capteurs usuellement agencés autour du moteur et/ou de l'actionneur ne permettent pas toujours d'obtenir toutes les mesures souhaitées pour surveiller différents paramètres électriques et mécaniques de la chaîne d'actionnement. Par exemple, ces capteurs ne permettent pas de mesurer le couple électromagnétique du moteur dont pourraient pourtant être déduits des paramètres intéressants pour surveiller la chaîne d'actionnement.
Il a été envisagé d'effectuer la mesure du couple électromagnétique lorsque l'aéronef est au sol à l'aide d'appareils de mesure extérieurs.
Néanmoins ceci nécessite que l'aéronef soit disponible au sol suffisamment longtemps et régulièrement pour que les mesures puissent être effectuées et renouvelées régulièrement afin de tenir compte de l'usure du moteur et de l'actionneur.
Il a ensuite été envisagé d'intégrer un capteur supplémentaire de couple électromagnétique sur l'aéronef.
Toutefois ceci entraîne nécessairement des augmentations de coûts mais également de masses et d'encombrements ce qui n'est pas souhaitable notamment dans le domaine de l'aviation.
Le document CN101964624B divulgue un système de surveillance sans capteur d'un moteur synchrone à aimant permanent à faible vitesse. Ce système se base sur l'estimation du flux magnétique et du courant dans le moteur et sur la mesure de force contre-électromotrice du moteur.

OBJET DE L'INVENTION

Un but de l'invention est de proposer un procédé de surveillance d'un système d'actionnement électromécanique obviant aux inconvénients précités.

BREVE DESCRIPTION DE L'INVENTION

A cet effet, l'invention a pour objet un procédé de surveillance d'un système d'actionnement électromécanique comportant au moins un onduleur, un moteur alimenté par l'onduleur et un actionneur entraîné par le moteur, le procédé comportant les étapes de :

- estimer la chute de tension dans l'alimentation du moteur liée à des défauts de l'onduleur à l'aide d'un filtre de Kalman prenant en compte des données opérationnelles dont au moins une intensité du courant transmis par l'onduleur au moteur, une tension de commande de l'onduleur et une vitesse de rotation de l'arbre de sortie du moteur,
- estimer au moins le coefficient de couple électromagnétique du moteur en prenant en compte la chute de tension estimée et des données opérationnelles dont l'intensité du courant transmis par l'onduleur au moteur, la tension de commande de l'onduleur ainsi que la dérivée de l'intensité du courant transmis par l'onduleur au moteur et la vitesse de rotation de l'arbre de sortie du moteur,
- calculer le couple électromagnétique du moteur à partir du coefficient de couple électromagnétique du moteur et de la donnée opérationnelle qu'est l'intensité du courant transmis par l'onduleur au moteur.

Le procédé selon l'invention permet d'estimer directement par calculs le couple électromagnétique ce qui évite d'avoir à embarquer un lourd et coûteux capteur spécifique avec le système d'actionnement électromécanique pour mesurer cette grandeur. On peut ainsi éventuellement déduire de ce couple électromagnétique, différents paramètres mécaniques supplémentaires comme par exemple le rendement de l'ensemble moteur/actionneur, le coefficient de frottement visqueux et le couple de frottement sec représentant tous deux les frictions mécaniques de l'ensemble moteur/actionneur. Cette estimation du couple électromagnétique prend avantageusement en compte les incertitudes sur les perturbations dues aux défauts de l'onduleur qui se traduisent par des chutes de tension engendrées par les temps morts ainsi que les pertes par commutation et par conduction. L'estimation du couple électromagnétique s'avère donc relativement précise.

En outre, le calcul du couple électromagnétique s'effectue directement en service et ne nécessite donc pas de manoeuvres spécifiques et d'immobilisation du dispositif portant le système d'actionnement électromécanique pour effectuer ces manoeuvres.

Pour la présente demande, le terme « données opérationnelles » désigne les données acquises lorsque le système d'actionnement électromécanique est en service et est sollicité naturellement, par opposition à des données qui seraient obtenues par une immobilisation voulue et dédiée du système d'actionnement électromécanique ou à des données qui seraient obtenues lors de manoeuvres spécifiques du système d'actionnement électromécanique provoquées expressément pour obtenir ces données. Dans le cas où le système d'actionnement électromécanique est embarqué dans un aéronef, le procédé selon l'invention utilise donc comme données opérationnelles les données mesurées en vol (au cours par exemple d'un décollage, d'un atterrissage, d'un virage ... qui ne sont pas provoqués volontairement pour solliciter le système d'actionnement électromécanique afin d'en retirer lesdites données) et non durant une opération de maintenance de l'aéronef au sol.

Selon un mode de réalisation particulier, le procédé comporte comme étape supplémentaire d'estimer au moins un paramètre mécanique du système d'actionnement électromécanique à partir du couple électromagnétique, de données opérationnelles dont au moins la vitesse de rotation l'arbre de sortie du moteur et la force aérodynamique subie par l'actionneur.

Selon un mode de réalisation particulier, le paramètre mécanique est le coefficient de frottement visqueux et/ou le couple de frottement sec dynamique et/ou le rendement de l'ensemble moteur et actionneur.

Selon un mode de réalisation particulier, le procédé comporte comme étape supplémentaire de former une base de données et de remplir ladite base avec les estimations d'au moins le couple électromagnétique du moteur.

Selon un mode de réalisation particulier, on remplit également la base d'autres paramètres électriques et mécaniques que le couple électromagnétique du moteur dont au moins une résistance du moteur et/ou, des inductances statoriques du moteur et/ou le coefficient de frottement visqueux de l'ensemble moteur et actionneur et/ou le couple de frottement sec dynamique de l'ensemble moteur et actionneur et/ou le rendement direct de l'ensemble moteur et actionneur et/ou le rendement indirect de l'ensemble moteur et actionneur.

D'autres caractéristiques et avantages de l'invention ressortiront de la description donnée ci-après d'une mise en oeuvre particulière de l'invention.

BREVE DESCRIPTION DES DESSINS

L'invention sera mieux comprise à la lumière de la description qui suit d'une mise en oeuvre particulière non limitative de l'invention. Il sera fait référence aux figures ci-jointes parmi lesquelles:

- la figure 1 est une vue schématique du système d'actionnement électromécanique mettant en oeuvre le procédé selon le mode particulier de mise en oeuvre de l'invention,
- la figure 2 est un schéma représentant les différentes étapes du procédé mis en oeuvre par le système schématisé à la figure 1,
- les figures 3a et 3b sont des schémas électriques modélisant une partie électrique du système représenté à la figure 1 dans un repère rotorique respectivement sur l'axe d et l'axe q.

DESCRIPTION DETAILLEE DE L'INVENTION

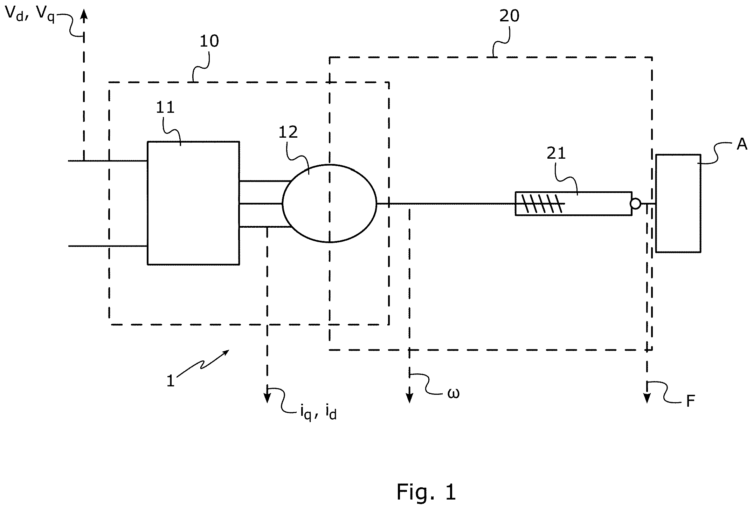

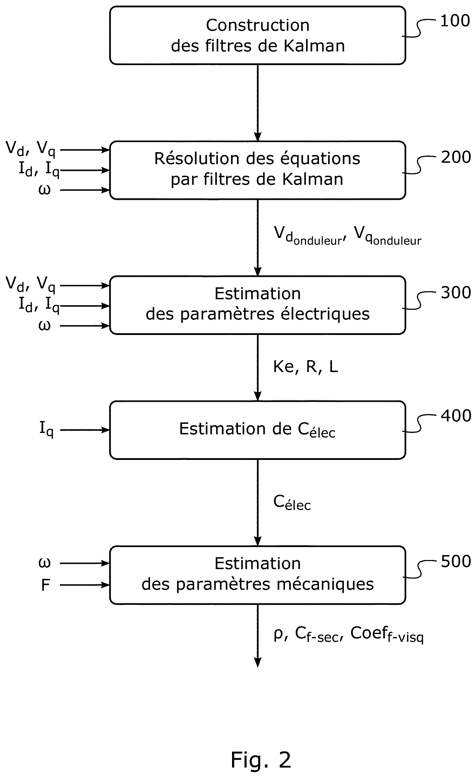

En référence aux figures 1 et 2, le procédé de surveillance selon une mise en oeuvre particulière de l'invention s'applique ici à un système d'actionnement électromécanique 1 d'un aileron A d'un aéronef. Cette application n'est bien sûr pas limitative et on pourra mettre en oeuvre le procédé selon l'invention dans un autre système d'actionnement électromécanique, tel qu'un système d'actionnement électromécanique associé à un capot d'un inverseur de poussée d'un aéronef, un volet ou une gouverne

Le système d'actionnement électromécanique 1 comporte ici une partie électrique 10 comprenant un onduleur 11 et un moteur 12 alimenté par l'onduleur 11. Le moteur 12 est ici un moteur synchrone à aimants permanents. Le système d'actionnement électromécanique 1 comporte par ailleurs une partie mécanique 20 comprenant le moteur 12 ainsi qu'un actionneur 21 qui est relié d'une part à l'arbre de sortie du moteur 12 et d'autre part à l'aileron A pour pouvoir déplacer l'aileron A. L'actionneur 21 est ici de type linéaire et comporte par exemple un vérin de type vis à billes ou un vérin de type vis à rouleaux. En variante, l'actionneur est de type rotatif. Dès lors, lorsque le moteur 12 est alimenté, il entraîne l'actionneur 21 qui déplace à son tour l'aileron A associé.

Le procédé selon l'invention permet donc de surveiller ce système d'actionnement électromécanique 1 comme cela va être à présent détaillé.

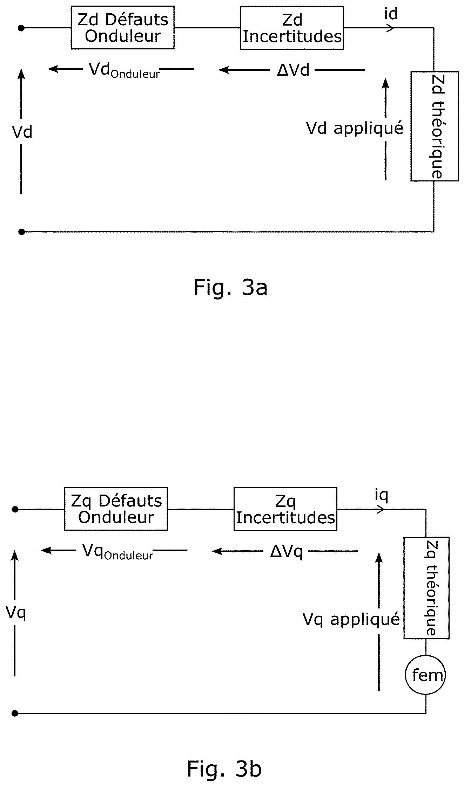

Du fait que l'alimentation du moteur 12 par l'onduleur 11 se fasse en courant triphasé, la modélisation de la partie électrique 10 est effectuée dans un repère rotorique (axe direct et axe en quadrature) comme visible aux figures 3a et 3b. Les différentes grandeurs électriques calculées ou mesurées dans le présent procédé sont donc projetées sur les deux premiers axes du modèle diphasé à savoir l'axe d (direct) et l'axe q (quadrature). Pour la suite de la description, l'indice d se réfère à la projection de la grandeur sur l'axe d et l'indice q à la projection de la grandeur sur l'axe q.

Afin d'estimer les chutes de tension dans l'alimentation du moteur 12 qui sont liées aux défauts de l'onduleur 11, la première étape 100 du procédé consiste à construire des filtres de Kalman linéaires, stationnaires et stochastiques de type :

$$\dot{x}(t) = Ax(t) + Bu(t) + Mw(t) \quad (1)$$

$$y(t) = Cx(t) + Du(t) + v(t) \quad (2)$$

en continu ou

$$\dot{x}(k+1) = A_{dis}x(k) + B_{dis}u(k) + M_{dis}w(k)$$

$$y(k) = C_{dis}x(k) + D_{dis}u(k) + v(k)$$

en discret.

Un tel modèle de Kalman est bien connu de l'homme du métier et ne sera donc pas détaillé ici. Pour plus d'informations on peut par exemple se référer au livre « Stochastic Models, Estimation and Control », Volume 141-1, Mathematics in Science and Engineering de P.S. Maybeck.

Pour appliquer l'estimateur de Kalman, on pose les équations suivantes du moteur synchrone 12 dans le repère rotorique :

$$\sqrt{\frac{2}{3}}\left(V_d + V_{d_{Onduleur}}\right) = Ri_d + L_d\frac{d}{dt}i_d - L_q p.\omega.i_q - \sqrt{\frac{2}{3}}\Delta V_d \quad (3)$$

$$\sqrt{\frac{2}{3}}\left(V_q + V_{q_{Onduleur}}\right) = Ri_q + L_q\frac{d}{dt}i_q + L_d p.\omega.i_d + \omega.Ke - \sqrt{\frac{2}{3}}\Delta V_q$$

avec $V_d$, $V_q$ les tension d'alimentation qui sont commandées à l'onduleur 11 appelées tensions de commande (qui sont ici mesurées au niveau de la boucle de régulation en courant de l'onduleur 11), $V_{d_{Onduleur}}$ $V_{q_{Onduleur}}$ les chutes de tension de l'onduleur dues aux défauts de l'onduleur, $\Delta V_d$ $\Delta V_q$ les incertitudes sur les chutes de tension de l'onduleur dues aux incertitudes de différents paramètres électriques de la partie électrique 10, $i_d$ et $i_q$ les intensités du courant transmis par l'onduleur 11 au moteur 12 (qui sont ici mesurées au niveau du moteur 12), R la résistance du moteur 12, $L_q$ et $L_d$ les inductances des phases statoriques du moteur 12, p le nombre de paires de pôles du moteur 12, $\omega$ la vitesse de rotation de l'arbre de sortie du moteur 12 et Ke le coefficient de couple électromagnétique du moteur 12.

Les données $i_d$, $i_q$, $V_d$, $V_q$ et $\omega$ sont des données opérationnelles qui sont mesurées par des capteurs ou récupérées à partir des commandes transmises par le calculateur à l'onduleur 11 lors du vol de l'aéronef, soit en temps réel soit en étant mesurées/récupérées puis stockées sur une mémoire (par exemple du calculateur) pour un usage ultérieur par le procédé selon l'invention.

Avant d'établir le modèle de Kalman pour estimer les chutes de tensions dues aux défauts onduleurs $V_{d_{Onduleur}}$ et $V_{q_{Onduleur}}$ on considère les trois hypothèses suivantes.

Selon une première hypothèse, les chutes de tensions dues aux défauts onduleurs $V_{d_{Onduleur}}^{35}$ et $V_{q_{Onduleur}}^{35}$ sont des variables de type intégrale associées à des variables aléatoires $w_d(t)$ et $w_q(t)$ de type bruits blancs sans biais et avec une densité spectrale de puissance connue, c'est-à-dire :

$$\frac{dV_{d_{Onduleur}}}{dt} = w_d(t)$$

$$\frac{dV_{q_{Onduleur}}}{dt} = w_q(t)$$

Selon une deuxième hypothèse, on considère les changements de variables suivants permettant un découplage :

$$U_d = \sqrt{\frac{2}{3}}V_d + L_q p.\omega.i_q$$

$$U_q = \sqrt{\frac{2}{3}}V_q - L_d p.\omega.i_d - \omega.Ke$$

Selon une troisième hypothèse, toutes les conditions de convergence de Kalman sont réalisées. Pour plus d'informations on peut par exemple se référer au livre « Stochastic Models, Estimation and Control », Volume 141-1, Mathematics in Science and Engineering de P.S. Maybeck.

Ainsi, le modèle final permettant d'estimer les chutes de tensions dues aux défauts de l'onduleur 11 $V_{q_{Onduleur}}$ et $V_{q_{Onduleur}}$ est donné par les représentations d'états suivantes :

$$\begin{bmatrix} \frac{d}{dt}i_d \\ \frac{dV_{d_{Onduleur}}}{dt} \end{bmatrix} = \begin{bmatrix} -\frac{R}{L_d} & \frac{1}{L_d}\sqrt{\frac{2}{3}} \\ 0 & 0 \end{bmatrix} \begin{bmatrix} i_d \\ V_{d_{Onduleur}} \end{bmatrix} + \begin{bmatrix} \frac{1}{L_d} \\ 0 \end{bmatrix} U_d + \begin{bmatrix} \frac{1}{L_d}\sqrt{\frac{2}{3}} & 0 \\ 0 & 1 \end{bmatrix} \begin{bmatrix} \Delta V_d \\ w_d(t) \end{bmatrix}$$

$$\begin{bmatrix} \frac{d}{dt}i_q \\ \frac{dV_{q_{Onduleur}}}{dt} \end{bmatrix} = \begin{bmatrix} -\frac{R}{L_q} & \frac{1}{L_q}\sqrt{\frac{2}{3}} \\ 0 & 0 \end{bmatrix} \begin{bmatrix} i_q \\ V_{q_{Onduleur}} \end{bmatrix} + \begin{bmatrix} \frac{1}{L_q} \\ 0 \end{bmatrix} U_q + \begin{bmatrix} \frac{1}{L_q}\sqrt{\frac{2}{3}} & 0 \\ 0 & 1 \end{bmatrix} \begin{bmatrix} \Delta V_q \\ w_q(t) \end{bmatrix}$$

On retrouve donc les représentations d'état à la forme générale (1) et (2) pour les deux axes d et q avec :

$$x(t) = \begin{bmatrix} i_d \\ V_{d_{Onduleur}} \end{bmatrix}, A = \begin{bmatrix} -\frac{R}{L_d} & \frac{1}{L_d}\sqrt{\frac{2}{3}} \\ 0 & 0 \end{bmatrix}, B = \begin{bmatrix} \frac{1}{L_d} \\ 0 \end{bmatrix}, M = \begin{bmatrix} \frac{1}{L_d}\sqrt{\frac{2}{3}} & 0 \\ 0 & 1 \end{bmatrix}, w(t) = \begin{bmatrix} \Delta V_d \\ w_d(t) \end{bmatrix}$$

$$x(t) = \begin{bmatrix} i_q \\ V_{q_{Onduleur}} \end{bmatrix}, A = \begin{bmatrix} -\frac{R}{L_q} & \frac{1}{L_q}\sqrt{\frac{2}{3}} \\ 0 & 0 \end{bmatrix}, B = \begin{bmatrix} \frac{1}{L_q} \\ 0 \end{bmatrix}, M = \begin{bmatrix} \frac{1}{L_q}\sqrt{\frac{2}{3}} & 0 \\ 0 & 1 \end{bmatrix}, w(t) = \begin{bmatrix} \Delta V_q \\ w_q(t) \end{bmatrix}$$

et pour les matrices de sortie :

$$C = \begin{bmatrix} R & 0 \end{bmatrix}, D = \begin{bmatrix} 0 \end{bmatrix}.$$

Le procédé permet ainsi d'établir deux modèles de Kalman pour le système d'actionnement électromécanique 1 selon l'axe d et selon l'axe q, modèles qu'il convient de traiter de façon indépendante.

Pour ces deux modèles de Kalman, les constantes R, $L_q$ et $L_d$ et $K_e$ sont des valeurs théoriques. Les incertitudes sur ces valeurs sont considérées comme une perturbation extérieure, perturbation déjà prise en compte dans ces deux modèles de Kalman. On peut par exemple se baser sur les données du constructeur pour imposer ces valeurs. De même, p est connu par exemple par données constructeurs.

Une fois les deux modèles de Kalman établis, le procédé comporte donc comme deuxième étape 200 de déterminer l'état x(t) de ces deux modèles par filtres de Kalman.

A cet effet, on discrétise ici les deux modèles énoncés ci-dessus.

Une telle discrétisation de modèle de Kalman et l'application de l'algorithme de Kalman à ce modèle discrétisé sont bien connus de l'homme du métier et ne seront donc pas détaillés ici. Pour plus de de détails sur la discrétisation des deux modèles de Kalman et sur les équations de récurrence de l'algorithme de Kalman on peut par exemple se référer au livre « Stochastic Models, Estimation and Control », Volume 141-1, Mathematics in Science and Engineering de P.S. Maybeck.

L'algorithme de Kalman, connu en soi, appliqué aux deux modèles de Kalman discrétisés permet ainsi d'obtenir une estimation de x(t) et donc par-là de la chute de tension de l'onduleur 11 $V_{d_{onduleur}}$, $V_{q_{onduleur}}$ sur les deux axes d et q à partir donc des données opérationnelles $i_d$, $i_q$, $V_d$, $V_q$ et $\omega$. Une fois la chute de tension de l'onduleur 11 estimée, le procédé comporte comme troisième étape 300 d'estimer plusieurs paramètres électriques liés au système d'actionnement électromécanique 1 dont au moins la constante de couple du moteur $Ke_{est}$. De préférence, le procédé permet d'estimer d'autres paramètres électriques à savoir $R_{est}$ la résistance du moteur 12 et $L_{est}$ l'inductance du moteur 12, étant entendu que dans la première étape les valeurs R, Ld et Lq étaient fixées à des valeurs théoriques nominales choisies d'après les données constructeurs.

A cet effet on rappelle que les équations électriques (3) posées précédemment peuvent être écrites avec les paramètres réels sous la forme :

$$\begin{cases} \sqrt{\dfrac{2}{3}}(V_d + V_{d_{onduleur}}) = R_{réel}i_d + L_{d_{réel}}\dfrac{di_d}{dt} - L_{q_{réel}}p\omega i_q \qquad (4) \\[4mm] \sqrt{\dfrac{2}{3}}(V_q + V_{q_{onduleur}}) = R_{réel}i_q + L_{q_{réel}}\dfrac{di_q}{dt} + L_{d_{réel}}p\omega i_d + \omega K_{e_{réel}} \end{cases}$$

On pose comme hypothèse que $L_{qréel} = L_{dréel} = L_{réel}$.

A partir de cette hypothèse et au système d'équations (4), on aboutit au système d'équations linéaires (5) suivant correspondant aux n-ièmes mesures effectuées et utilisées dans le procédé (intensité fournie par l'onduleur 11 au moteur 12, tension de commande et vitesse de rotation de l'arbre de sortie du moteur 12) :

$$\begin{cases} \sqrt{\dfrac{2}{3}}(V_d(t_n) + V_{d_{onduleur}}(t_n)) = R_{réel}(t_n)i_d(t_n) + L_{réel}(t_n)\dfrac{di_d(t_n)}{dt_n} - L_{réel}(t_n)p\omega(t_n)i_q(t_n) \qquad (5) \\[4mm] \sqrt{\dfrac{2}{3}}(V_q(t_n) + V_{q_{onduleur}}(t_n)) = R_{réel}(t_n)i_q(t_n) + L_{réel}(t_n)\dfrac{di_q(t_n)}{dt_n} + L_{réel}(t_n)p\omega(t_n)i_d(t_n) + \omega(t_n)K_{e_{réel}}(t_n) \end{cases}$$

qu'on peut également écrire sous la forme $X_n = h_n\theta_{n_{réel}}$ avec :

$$X_n = \begin{bmatrix} \sqrt{\dfrac{2}{3}}(V_d(t_n) + V_{d_{onduleur}}(t_n)) \\[4mm] \sqrt{\dfrac{2}{3}}(V_q(t_n) + V_{q_{onduleur}}(t_n)) \end{bmatrix}$$

$$h_n = \begin{bmatrix} i_d(t_n) & (\dfrac{di_d(t_n)}{dt_n} - p\omega(t_n)i_q(t_n)) & 0 \\ i_q(t_n) & (\dfrac{di_q(t_n)}{dt_n} + p\omega(t_n)i_d(t_n)) & \omega(t_n) \end{bmatrix}$$

$$\theta_{n_{r\acute{e}el}} = \begin{bmatrix} R_{r\acute{e}el}(t_n) \\ L_{r\acute{e}el}(t_n) \\ K_{e_{r\acute{e}el}}(t_n) \end{bmatrix}$$

Toutefois, comme il a déjà été indiqué, les mesures effectuées et utilisées par le système d'actionnement électromécanique 1 s'avèrent le plus souvent bruitées. Pour rendre le système d'équations (5) plus réaliste en faisant prendre en compte ces incertitudes sur les mesures, on introduit dans ce système d'équations un vecteur $v_n$ correspondant à un bruit blanc non biaisé ce qui donne :

$$Y_n = h_n \theta_{n_{est}} - v_n$$

$$Y_n = \begin{bmatrix} \sqrt{\dfrac{2}{3}}(V_d(t_n) + V_{d_{onduleur}}(t_n)) \\ \sqrt{\dfrac{2}{3}}(V_q(t_n) + V_{q_{onduleur}}(t_n)) \end{bmatrix}$$

$$h_n = \begin{bmatrix} i_d(t_n) & (\dfrac{di_d(t_n)}{dt_n} - p\omega(t_n)i_q(t_n)) & 0 \\ i_q(t_n) & (\dfrac{di_q(t_n)}{dt_n} + p\omega(t_n)i_d(t_n)) & \omega(t_n) \end{bmatrix}$$

$$\theta_{n_{est}} = \begin{bmatrix} R_{est}(t_n) \\ L_{est}(t_n) \\ K_{e_{est}}(t_n) \end{bmatrix}$$

Sachant que les données $V_{d_{onduleur}}$ et $V_{q_{onduleur}}$ ont été estimées à l'étape 200 précédente, que la donnée p est connue (par données constructeurs) et que les données $i_d$, $i_q$, $V_d$, $V_q$ et $\omega$ sont donc des données mesurées, il reste seul à déterminer le vecteur paramètre $\theta_{n_{est}}$.

Cette détermination est ici mise en oeuvre par un calcul stochastique. Plus précisément ici, cette détermination est mise en oeuvre par un algorithme des moindres carrés récursifs permettant de chercher $\theta_{n_{est}}$ en minimisant le critère $\varepsilon_n = (Y_n - X_n)^T (Y_n - X_n)$.

Un tel algorithme est bien connu de l'homme du métier et ne sera donc pas détaillé ici. Pour plus de de détails on peut par exemple se référer au livre « Stochastic Models, Estimation and Control », Volume 141-1, Mathematics in Science and Engineering de P.S. Maybeck.

Ceci permet donc d'estimer le coefficient de couple électromagnétique du moteur $Ke_{est}$, la résistance du moteur $R_{est}$ et l'inductance du moteur $L_{est}$. Ceci permet de surveiller l'état de santé du système d'actionnement électromécanique 1 à partir des lois de vieillissement connus dudit système et de ces paramètres estimés et/ou mettre en place des opérations de maintenance éventuellement préventives lors d'un prochain séjour de l'aéronef au sol.

Une fois le coefficient de couple électromagnétique du moteur $Ke_{est}$ estimé, le procédé comporte comme quatrième étape 400 de calculer le couple électromagnétique du moteur $C_{élec}$ à l'aide de la formule suivante :

$$C_{elec} = \frac{3}{2} Ke_{phase} i_q + \frac{3}{2} Ke_{phase} \Delta i_q$$

avec $\Delta i_q$ l'erreur sur la mesure de courant qui est bornée.

De préférence, le procédé comporte une cinquième étape 500 d'estimation de plusieurs paramètres mécaniques liés au système d'actionnement électromécanique 1 à savoir le coefficient de frottement visqueux $Coef_{f\text{-visq}}$ de la partie mécanique 20, le couple de frottement sec dynamique $C_{f\text{-sec}}$ de la partie mécanique 20 et le rendement direct $\rho_{direct}$ de la partie mécanique 20 (c'est-à-dire le rendement lorsque la charge reliée au moteur s'oppose au mouvement de l'arbre de sortie du moteur par opposition au rendement indirect $\rho$eindirect qui correspond au rendement lorsque la charge reliée au moteur accompagne le mouvement de l'arbre de sortie du moteur, la relation entre le rendement direct et le rendement indirect étant donné par

$$\left( \frac{1}{\rho_{direct}} - 1 \right) = \left( 1 - \rho_{indirect} \right) ).$$

A cet effet le principe fondamental de la dynamique appliqué sur l'arbre de sortie du moteur 12 donne :

$$C_{elec} + C_{charge} - Coef_{f\_visq}\omega - signe(\omega)(C_{f\_sec} + \left| C_{charge} \right| (\frac{1}{\rho_{direct}} - 1)) = J_{mot} \frac{d\omega}{dt}$$

avec $C_{charge} = F \dfrac{pas_{vis}}{2\pi}$ , F étant la force aérodynamique subie par l'actionneur 21 qui est mesurée à l'aide d'un capteur porté par l'actionneur 21, et $J_{mot}$ le moment d'inertie du système ramenée sur l'arbre du moteur 12.

$$K_{rendement} = \frac{1}{\rho_{direct}} - 1$$

On pose

$$J_{mot} \frac{d\omega(t_n)}{dt_n} - C_{elec} - C_{charge} = \begin{bmatrix} -\omega & -signe(\omega) & -signe(\omega) \left| C_{charge} \right| \end{bmatrix} \begin{bmatrix} Coef_{f\_vis} \\ C_{f\_sec} \\ K_{rendement} \end{bmatrix}$$

$$J_{mot} \frac{d\omega}{dt} - C_{elec} - C_{charge} = \begin{bmatrix} -\omega & -signe(\omega) & -signe(\omega) \left| C_{charge} \right| \end{bmatrix} \begin{bmatrix} Coef_{f\_visq} \\ C_{f\_sec} \\ K_{rendement} \end{bmatrix} \quad (6)$$

On aboutit à l'équation linéaire suivante correspondant aux n-ièmes mesures effectuées et utilisées dans le procédé:

$$J_{mot} \frac{d\omega(t_n)}{dt_n} - C_{elec}(t_n) - C_{charge}(t_n) = \begin{bmatrix} -\omega(t_n) & -signe(\omega(t_n)) & -signe(\omega(t_n)) \left| C_{charge}(t_n) \right| \end{bmatrix} \begin{bmatrix} Coef_{f\_visq} \\ C_{f\_sec} \\ K_{rendement} \end{bmatrix} \quad (6)$$

qu'on peut également écrire sous la forme $X_n = h_n \theta_n$ avec :

$$\mathbf{X_n} = \left[ J_{mot}\frac{d\omega(t_n)}{dt_n} - C_{elec}(t_n) - C_{charge}(t_n) \right]$$

$$\mathbf{h_n} = \left[ -\omega(t_n) \quad -signe(\omega(t_n)) \quad -signe(\omega(t_n))\left|C_{charge}(t_n)\right| \right]$$

$$\mathbf{\theta_n} = \begin{bmatrix} Coef_{f\_visq} \\ C_{f\_sec} \\ K_{rendement} \end{bmatrix}$$

Toutefois, comme il a déjà été indiqué, les mesures effectuées et utilisées par le système d'actionnement électromécanique 1 s'avèrent le plus souvent bruitées. Du fait de l'erreur sur la mesure du courant $\Delta i_q$, il demeure ainsi une incertitude sur le couple électromagnétique du moteur $C_{élec}$. Pour rendre l'équation (6) plus réaliste, on modifie l'équation (6) pour lui faire prendre en compte cette incertitude. Ici on exprime l'incertitude sur le couple électromagnétique du moteur $C_{élec}$ par un bruit blanc centré $v_n$ de Densité Spectrale de Puissance connue :

$$\begin{cases} \Delta C_{elec}(t_n) = \upsilon_n = \dfrac{3}{2}Ke_{phase}\Delta i_q(t_n) \\[2mm] C_{elecnom}(t_n) = \dfrac{3}{2}Ke_{phase}i_q(t_n) \\[2mm] C_{elec}(t_n) = C_{elecnom}(t_n) + \Delta C_{elec}(t_n) \end{cases}$$

On obtient ainsi l'équation suivante :

$$Y_n = h_n\theta_{n_{est}} + v_n$$

$$Y_n = \left[ J_{mot}\frac{d\omega(t_n)}{dt_n} - C_{elecnom}(t_n) - C_{charge}(t_n) \right]$$

$$h_n = \left[ -\omega(t_n) \quad -signe(\omega(t_n)) \quad -signe(\omega(t_n))\left|C_{charge}(t_n)\right| \right]$$

$$\theta_{n_{est}} = \begin{bmatrix} Coef_{f\_vis_{est}} \\ C_{f\_sec_{est}} \\ K_{rendement\,est} \end{bmatrix}$$

L'accélération angulaire $\dfrac{d\omega}{dt}$ est ici calculée à partir de la vitesse angulaire $\omega$ mais peut en variante être mesurée au niveau du moteur 12. En outre, sachant que la donnée Ke a été estimée à la troisième étape 300, que les données $J_{mot}$ et $pas_{vis}$ sont connues et que les données $\omega$, $i_q$, F sont des données opérationnelles mesurées, il reste seul à déterminer le vecteur paramètre $\theta_{nest}$.

Cette détermination est ici mise en oeuvre par un calcul stochastique. Plus précisément ici, cette détermination est mise en oeuvre par un algorithme des moindres carrés récursifs permettant de chercher $\theta_n$ en minimisant le critère $\varepsilon n = (Y_n - X_n)^T (Y_n - X_n)$.

Par ailleurs, on rappelle ici que l'algorithme doit prendre en compte le fait que l'équation précédente ne peut s'appliquer que si la vitesse de rotation du moteur 12 est non nulle. Dès lors les paramètres estimés dans l'algorithme seront figés à la dernière valeur quand la vitesse de rotation du moteur 12 en valeur absolue est en dessous d'un certain seuil que l'on définit comme arbitrairement proche de zéro. De préférence, on ajuste ce seuil pour qu'il soit de plus en plus proche de zéro au fur et à mesure que le filtre de Kalman devient précis.

En considérant P la matrice d'autocorrélation de l'erreur d'estimation $\varepsilon_n$ et $R_v$ la matrice de covariance du bruit $v_n$, l'algorithme s'écrit :

$$si \quad \omega(n) < seuil \quad ou \quad si \quad -seuil < \omega(n)$$

$$K_n = K_{n-1}$$

$$\hat{\theta}_{n_{est}} = \hat{\theta}_{n-1est}$$

$$P_n = P_{n-1}$$

$$autrement$$

$$si \ n = 1 \ (conditions \ initiales) \ alors$$

$$K_n = P_{00}h_n \left[ R_v + h_n^T P_{00} h_n \right]^{-1}$$

$$\hat{\theta}_{n_{est}} = \hat{\theta}_{00_{est}} + K_n (Y_n - h_n^T \hat{\theta}_{00_{est}})$$

$$P_n = (I - K_n h_n^T) P_{00}$$

$$autrement$$

$$K_n = P_{n-1}h_n \left[ R_v + h_n^T P_{n-1} h_n \right]^{-1}$$

$$\hat{\theta}_{n_{est}} = \hat{\theta}_{n-1_{est}} + K_n (Y_n - h_n^T \hat{\theta}_{n-1_{est}})$$

$$P_n = (I - K_n h_n^T) P_{n-1}$$

Ceci permet donc d'estimer le coefficient de frottement visqueux $Coef_{f-visq}$, le couple de frottement sec dynamique $C_{f-sec}$ et le rendement direct $\rho_{direct}$. Ceci permet de surveiller l'état de santé du système d'actionnement électromécanique 1 partir des lois de vieillissement connus dudit système et de ces paramètres estimés. On peut ainsi par exemple estimer le vieillissement du système d'actionnement électromécanique 1 et/ou mettre en place des opérations de maintenance éventuellement préventives lors d'un prochain séjour de l'aéronef au sol.

Le procédé qui vient d'être décrit permet ainsi d'estimer différents paramètres électriques et mécaniques permettant de surveiller l'état de santé le système d'actionnement électromécanique 1. Comme il a déjà été indiqué le procédé est mis en oeuvre lors d'un vol réel de l'aéronef et non au cours de manoeuvre dédié à l'estimation de ces paramètres ou à une immobilisation de l'appareil.

Le procédé peut ainsi être mis en oeuvre directement au cours d'une manoeuvre de l'aéronef nécessitant la sollicitation du système d'actionnement électromécanique 1 ou bien une fois cette manoeuvre effectuée, les différentes mesures nécessaires à la mise en oeuvre du procédé ayant été enregistrées au cours de la manoeuvre pour être utilisées rétrospectivement par le procédé.

Les données obtenues par le procédé selon l'invention permettent ainsi de mettre en place différentes stratégies de surveillance et d'actions sur le système d'actionnement électromécanique 1. Par exemple, le procédé peut comporter l'étape supplémentaire de former une base de données intégrant les différentes valeurs des paramètres électriques et mécaniques estimées au cours du temps et des différents vols de l'aéronef. Cette base de données permettra ainsi de connaitre l'évolution des différents paramètres électriques et mécaniques du système dans le temps. Cette base de données pourra aussi servir pour faciliter la surveillance d'autres systèmes d'actionnement électromécanique.

Bien entendu l'invention n'est pas limitée à la mise en oeuvre décrite et on peut y apporter des variantes de réalisation sans sortir du cadre de l'invention tel que défini par les revendications.

**EP 3 391 161 B1**

## Revendications

1. Procédé de surveillance d'un système d'actionnement électromécanique (1) comportant au moins un onduleur (11), un moteur (12) alimenté par l'onduleur et un actionneur (21) entraîné par le moteur, le procédé comportant les étapes de :

   - estimer (100, 200) la chute de tension dans l'alimentation du moteur liée à des défauts de l'onduleur à l'aide d'un filtre de Kalman prenant en compte des données opérationnelles dont au moins une intensité du courant transmis par l'onduleur au moteur, une tension de commande de l'onduleur et une vitesse de rotation de l'arbre de sortie du moteur,
   - estimer (300) au moins le coefficient de couple électromagnétique du moteur en prenant en compte la chute de tension estimée et des données opérationnelles dont l'intensité du courant transmis par l'onduleur au moteur, la tension de commande de l'onduleur, la dérivée de l'intensité du courant transmis par l'onduleur au moteur et la vitesse de rotation de l'arbre de sortie du moteur, et
   - calculer (400) le couple électromagnétique du moteur à partir du coefficient de couple électromagnétique du moteur et de la donnée opérationnelle qu'est l'intensité du courant transmis par l'onduleur au moteur.

2. Procédé selon la revendication 1, dans lequel on estime, en même temps que le coefficient de couple électromagnétique du moteur, d'autres paramètres électriques du système d'actionnement électromécanique (1).

3. Procédé selon la revendication 2, dans lequel les autres paramètres électriques estimés sont la résistance du moteur et l'inductance du moteur.

4. Procédé selon l'une des revendications précédentes, comportant comme étape supplémentaire (500) d'estimer au moins un paramètre mécanique du système d'actionnement électromécanique (1) à partir du couple électromagnétique, de données opérationnelles dont au moins la vitesse de rotation l'arbre de sortie du moteur (12) et la force aérodynamique subie par l'actionneur (21).

5. Procédé selon la revendication 4, dans lequel le paramètre mécanique est le coefficient de frottement visqueux et/ou le couple de frottement sec dynamique et/ou le rendement de l'ensemble moteur et actionneur.

## Patentansprüche

1. Verfahren zur Überwachung eines elektromechanischen Betätigungssystems (1), das mindestens einen Wechselrichter (11), einen Motor (12), der von dem Wechselrichter gespeist wird, und einen Aktor (21) umfasst, der von dem Motor angetrieben wird, wobei das Verfahren die Schritte umfasst:

   - Schätzen (100, 200) des Spannungsabfalls in der Versorgung des Motors, der mit Fehlern des Wechselrichters in Verbindung steht, mit Hilfe eines Kalman-Filters, der Betriebsdaten berücksichtigt, darunter zumindest eine Intensität des Stroms, der von dem Wechselrichter zum Motor übertragen wird, eine Spannung zur Steuerung des Wechselrichters und eine Drehgeschwindigkeit der Abtriebswelle des Motors,
   - Schätzen (300) mindestens des Koeffizienten des elektromagnetischen Drehmoments des Motors unter Berücksichtigung des geschätzten Spannungsabfalls und der Betriebsdaten, darunter die Intensität des Stroms, der von dem Wechselrichter zum Motor übertragen wird, die Spannung zur Steuerung des Wechselrichters, der Ableitung der Intensität des Stroms, der von dem Wechselrichter zum Motor übertragen wird, und die Drehgeschwindigkeit der Abtriebswelle des Motors, und
   - Berechnen (400) des elektromagnetischen Drehmoments des Motors anhand des Koeffizienten des elektromagnetischen Drehmoments des Motors und des Betriebsdatenelements, das die Intensität des von dem Wechselrichter zum Motor übertragenen Stroms ist.

2. Verfahren nach Anspruch 1, bei dem man zur gleichen Zeit, zu der man den Koeffizienten des elektromagnetischen Drehmoments des Motors schätzt, weitere elektrische Parameter des elektromechanischen Betätigungssystems (1) schätzt.

3. Verfahren nach Anspruch 2, bei dem die geschätzten weiteren elektrischen Parameter der Widerstand des Motors und die Induktivität des Motors sind.

11

**4.** Verfahren nach einem der vorhergehenden Ansprüche, umfassend als zusätzlichen Schritt (500) das Schätzen mindestens eines mechanischen Parameters des elektromechanischen Betätigungssystems (1) anhand des elektromagnetischen Drehmoments, der Betriebsdaten, darunter mindestens die Drehgeschwindigkeit der Abtriebswelle des Motors (12) und die aerodynamische Kraft, die von dem Aktor (21) erfahren wird.

**5.** Verfahren nach Anspruch 4, bei dem der mechanische Parameter der viskose Reibungskoeffizient und/oder das dynamische Trockenreibungsmoment und/oder der Wirkungsgrad der Einheit aus Motor und Aktor ist.

**Claims**

**1.** A method of monitoring an electromechanical actuator system (1) including at least one inverter (11), a motor (12) powered by the inverter, and an actuator (21) driven by the motor, the method comprising the steps of:

. estimating (100, 200) the drop of voltage in the power supply to the motor associated with defects of the inverter by means of a Kalman filter taking account of operational data including at least one electric current delivered by the inverter to the motor, at least one control voltage of the inverter, and at least one speed of rotation of the outlet shaft of the motor;
. estimating (300) at least the electromagnetic torque coefficient of the motor by taking account of the estimated voltage drop and the operational data including the current delivered by the inverter to the motor, the control voltage of the inverter, the derivative of the current delivered by the inverter to the motor, and the speed of rotation of the outlet shaft of the motor; and
. calculating (400) the electromagnetic torque of the motor from the electromagnetic torque coefficient of the motor and the operational data constituted by the electric current delivered by the inverter to the motor.

**2.** A method according to claim 1, wherein at the same time as estimating the electromagnetic torque coefficient of the motor, other electrical parameters of the electromechanical actuator system (1) are also estimated.

**3.** A method according to claim 2, wherein the other electrical parameters that are estimated are the resistance of the motor and the inductance of the motor.

**4.** A method according to any preceding claim, including an additional step (500) of estimating at least one mechanical parameter of the electromechanical actuator system (1) from the electromagnetic torque, from operational data including at least the speed of rotation of the outlet shaft of the motor (12), and from the aerodynamic force to which the actuator (21) is subjected.

**5.** A method according to claim 4, wherein the mechanical parameter is the viscous friction coefficient and/or the dynamic drive friction torque and/or the efficiency of the assembly comprising the motor and the actuator.

Fig. 1

Fig. 2

Fig. 3a

Fig. 3b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 101964624 B

**Littérature non-brevet citée dans la description**

- Stochastic Models, Estimation and Control. Mathematics in Science and Engineering. P.S. Maybeck, vol. 141-1